(19) Europäisches Patentamt
European Patent Office
Office européen des brevets

(11) **EP 3 688 674 B1**

(12) **FASCICULE DE BREVET EUROPEEN**

(45) Date de publication et mention de la délivrance du brevet:
**13.10.2021   Bulletin 2021/41**

(21) Numéro de dépôt: **18792971.6**

(22) Date de dépôt: **25.09.2018**

(51) Int Cl.:
*G06N 3/063* (2006.01)          *H01L 27/24* (2006.01)
*H01L 45/00* (2006.01)

(86) Numéro de dépôt international:
**PCT/FR2018/052348**

(87) Numéro de publication internationale:
**WO 2019/063926 (04.04.2019 Gazette 2019/14)**

(54) **PROCEDE DE FABRICATION D'UN CALCULATEUR A RESEAUX DE NEURONES RECURRENTS**

VERFAHREN ZUR HERSTELLUNG EINES REKURRENTEN NEURONALEN NETZWERKCOMPUTERS

METHOD OF PRODUCING A RECURRENT NEURAL NETWORK COMPUTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:   **26.09.2017   FR 1758900**
**06.03.2018   FR 1851910**

(43) Date de publication de la demande:
**05.08.2020   Bulletin 2020/32**

(73) Titulaire: **Commissariat à l'Energie Atomique et aux Energies Alternatives**
**75015 Paris (FR)**

(72) Inventeurs:
• **VIANELLO, Elisa**
**38000 Grenoble (FR)**
• **CARABASSE, Catherine**
**38500 Coublevie (FR)**
• **LA BARBERA, Selina**
**38100 Grenoble (FR)**
• **TIRON, Raluca**
**38950 Saint-Martin-Le-Vinoux (FR)**

(74) Mandataire: **INNOV-GROUP**
**310, avenue Berthelot**
**69372 Lyon Cedex 08 (FR)**

(56) Documents cités:
**US-A1- 2010 220 523     US-A1- 2014 214 738**

• **DEMIS E C ET AL: "Atomic switch networks-nanoarchitectonic design of a complex system for natural computing", NANOTECHNOLOGY, vol. 26, no. 20, 204003, 27 avril 2015 (2015-04-27), XP020283967, ISSN: 0957-4484, DOI: 10.1088/0957-4484/26/20/204003 [extrait le 2015-04-27] cité dans la demande**
• **FRASCAROLI J ET AL: "Resistive Switching in High-Density Nanodevices Fabricated by Block Copolymer Self-Assembly", ACS NANO, vol. 9, no. 3, 5 mars 2015 (2015-03-05), pages 2518-2529, XP055491697, ISSN: 1936-0851, DOI: 10.1021/nn505131b**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

### Domaine technique

L'invention se rapporte au domaine technique des calculateurs à réseaux de neurones récurrents. Les réseaux de neurones récurrents sont des réseaux de neurones artificiels où les connexions entre les unités forment au moins un cycle au sens de la théorie des graphes. Plus précisément, le domaine technique concerne les réseaux de neurones récurrents entraînés par le paradigme « *Reservoir computing* ». Ce paradigme est un système dynamique hautement non-linéaire, comportant :

- une couche d'entrée ;
- une couche cachée, appelée réservoir, munie de connexions récurrentes fixées de manière aléatoire ;
- une couche de sortie (« *readout»* en langue anglaise).

Le principe de ce paradigme est de projeter la couche d'entrée vers le réservoir, puis de modifier les connexions allant du réservoir vers la couche de sortie par un apprentissage supervisé.

En d'autres termes, l'invention se rapporte à un calculateur qui est une implémentation physique ou matérielle (« *hardware* » en langue anglaise) du paradigme « *Reservoir computing ».*

L'invention trouve notamment son application dans la classification de tâches, l'extraction de caractéristiques, la poursuite d'objets (« *tracking»* en langue anglaise), la prédiction de mouvements en robotique, la reconnaissance vocale et la reconnaissance sonore.

### Etat de la technique antérieure

Un procédé de fabrication d'un calculateur à réseaux de neurones récurrents, connu de l'état de la technique, notamment du document « Atomic switch networks - nanoarchitectonic design of a complex systemfor natural computing », E.C. Demis et al., Nanotechnology, 26, 204003, 2015, comporte une étape de croissance aléatoire de nanofils d'argent sur une électrode structurée de platine. Le caractère aléatoire est obtenu par une étape préalable de formation de microsphères de cuivre sur l'électrode structurée. Les microsphères de cuivre forment une couche germe pour les nanofils d'argent. Le procédé comporte une étape de sulfuration des nanofils d'argent de manière à obtenir des structures du type $Ag/Ag_2S/Ag$. De telles structures forment des cellules de mémoire résistive de type interrupteur atomique.

Un tel procédé de l'état de la technique permet la fabrication d'un calculateur qui est une implémentation physique du paradigme *« Reservoir computing »*. Toutefois, un tel procédé de l'état de la technique n'est pas entièrement satisfaisant dans la mesure où le choix des matériaux pour la mémoire résistive est restreint. En effet, il est nécessaire de choisir un couple de matériaux compatible, de type conducteur électrique/diélectrique, pour la formation des nanofils et des cellules de mémoire résistive, en l'espèce $Ag/Ag_2S$.

US 2010/220523 A1 divulgue un autre procédé de fabrication d'un calculateur à réseaux de neurones récurrents, comportant la structuration d'une première électrode en un ensemble régulier utilisant une lithographie par faisceau d'électrons, suivie du dépôt d'une couche mémoire résistive en NiO, par exemple, sur la première électrode structurée, la formation d'une deuxième électrode sur la couche mémoire, et la structuration de la deuxième électrode, utilisant une méthode d'auto-assemblage utilisant des copolymères à blocs.

### Exposé de l'invention

L'invention vise à remédier en tout ou partie aux inconvénients précités. A cet effet, l'invention a pour objet un procédé de fabrication d'un calculateur à réseaux de neurones récurrents, comportant les étapes successives :

a) prévoir un substrat comportant une première électrode ;
b) former une première couche de copolymères à blocs sur une partie de la première électrode de sorte que la première électrode présente des zones libres avec une distribution spatiale aléatoire ;
c) graver les zones libres de la première électrode de manière à structurer la première électrode ;
d) retirer la première couche de copolymères à blocs ;
e) former une couche mémoire, de type mémoire vive résistive, sur la première électrode structurée lors de l'étape c) ;
f) former une deuxième électrode sur la couche mémoire ;
g) former une deuxième couche de copolymère à blocs sur une partie de la deuxième électrode de sorte que la deuxième électrode présente des zones libres avec une distribution spatiale aléatoire ;
h) graver les zones libres de la deuxième électrode de manière à structurer la deuxième électrode ;
i) retirer la deuxième couche de copolymères à blocs.

Ainsi, un tel procédé selon l'invention permet l'implémentation physique d'un calculateur à réseaux de neurones récurrents pouvant être entraînés par le paradigme « *Reservoir Computing* ». En effet, les copolymères à bloc possèdent la propriété de s'auto-assembler en réseaux denses d'objets nanométriques avec la capacité de former un masque de lithographie.

Cet auto-assemblage introduit le caractère aléatoire nécessaire dans le paradigme « *Reservoir Computing* », c'est-à-dire par exemple :

- des connexions récurrentes fixées de manière aléatoire dans le réservoir ;
- un nombre stochastique d'unités (une unité correspondant à une cellule de mémoire vive résistive, située à une intersection entre les première et deuxième électrodes) ;
- un temps de latence aléatoire entre les unités (e.g. une distance aléatoire entre les unités) ;
- un poids aléatoire des unités par une conductance aléatoire des cellules de la mémoire résistive (les cellules de la mémoire résistive étant formées par les zones d'intersection entre la couche mémoire et les première et deuxième électrodes).

En outre, le masque de lithographie ainsi formé par les première et deuxième couches de copolymères à blocs permet de structurer les première et deuxième électrodes lors des étapes c) et h).

Enfin, un tel procédé selon l'invention autorise une liberté sur le choix du matériau de la couche mémoire dans la mesure où la couche mémoire est formée indépendamment des première et deuxième couches de copolymères à blocs.

Définitions

- Par « électrode structurée », on entend une électrode présentant une surface discontinue délimitant un ensemble de motifs.
- Par « zones libres » on entend des zones de l'électrode qui ne sont pas recouvertes par la couche de copolymère à blocs.
- Par « couche mémoire », on entend une couche ou une pluralité de sous-couches (par exemple réalisée(s) dans un matériau de type oxyde ou de type chalcogénure) formant, avec les première et deuxième électrodes, une mémoire vive résistive (ReRam « *Resistive random-access memory* » en langue anglaise). Plus précisément, les cellules de la mémoire vive résistive sont situées aux intersections entre les première et deuxième électrodes.

Le procédé selon l'invention peut comporter une ou plusieurs des caractéristiques suivantes.

Selon une caractéristique de l'invention, l'étape b) comporte les étapes successives :

$b_1$) former une couche d'un polymère aléatoire sur la première électrode ;
$b_2$) greffer la couche du polymère aléatoire sur une partie de la première électrode ;
$b_3$) former la première couche de copolymères à blocs sur la couche du polymère aléatoire greffée lors de l'étape $b_2$) ;
$b_4$) retirer la couche du polymère aléatoire greffée.

Par « polymère aléatoire », on entend un polymère possédant une pelote aléatoire.

Ainsi, la couche du polymère aléatoire est une couche de fonctionnalisation permettant de contrôler les énergies de surface de la première électrode. Un avantage procuré est d'accentuer le caractère aléatoire et d'améliorer la qualité de la formation de la première couche de copolymères à blocs.

Selon une caractéristique de l'invention, l'étape g) comporte les étapes successives :

$g_1$) former une couche d'un polymère aléatoire sur la deuxième électrode ;
$g_2$) greffer la couche du polymère aléatoire sur une partie de la deuxième électrode ;
$g_3$) former la deuxième couche de copolymères à blocs sur la couche du polymère aléatoire greffée lors de l'étape $g_2$) ;
$g_4$) retirer la couche du polymère aléatoire greffée.

Ainsi, la couche du polymère aléatoire est une couche de fonctionnalisation permettant de contrôler les énergies de surface de la deuxième électrode. Un avantage procuré est d'accentuer le caractère aléatoire et d'améliorer la qualité de la formation de la deuxième couche de copolymères à blocs.

Selon une caractéristique de l'invention, le polymère aléatoire est sélectionné dans le groupe comportant un copolymère statistique, un homopolymère, une monocouche auto-assemblée.

Selon une caractéristique de l'invention, les copolymères à blocs de la première couche et de la deuxième couche sont sélectionnés dans le groupe comportant :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO,
- le polystyrène et le poly(2-vinyl pyridine), noté PS-P2VP.

Selon une caractéristique de l'invention, la couche mémoire est réalisée dans au moins un matériau sélectionné dans le groupe comportant $HfO_2$, $Al_2O_3$, $SiO_2$, $ZrO$, un oxyde de titane, un chalcogénure, $Ta_2O_5$.

Selon une caractéristique de l'invention, les première et deuxième électrodes sont réalisées dans au moins un matériau sélectionné dans le groupe comportant Ti, TiN, Pt, Zr, Al, Hf, Ta, TaN, C, Cu, Ag.

Selon une caractéristique de l'invention, la première couche de copolymères à blocs et la deuxième couche de copolymères à blocs formées respectivement lors des étapes b) et g) présentent une épaisseur comprise entre 30 nm et 50 nm.

Ainsi, un avantage procuré est d'obtenir un masque de lithographie de bonne qualité pour structurer les première et deuxième électrodes.

Selon une caractéristique de l'invention, le procédé comporte une étape j) consistant à former une couche d'encapsulation sur la deuxième électrode structurée lors de l'étape h), l'étape j) étant exécutée après l'étape i).

Ainsi, un avantage procuré est de protéger le calculateur de l'air et de l'humidité.

Selon une caractéristique de l'invention, la première électrode structurée lors de l'étape c) présente un pas, noté p, et l'étape e) est exécutée de sorte que la couche mémoire présente une épaisseur, notée E, vérifiant :

$$p/2 \leq E \leq p.$$

Ainsi, une telle épaisseur E de la couche mémoire permet d'obtenir une topologie de surface quasi-plane de manière à faciliter la formation de la deuxième électrode lors de l'étape f), tout en s'affranchissant d'une étape de polissage mécano-chimique.

L'invention a également pour objet un calculateur à réseaux de neurones récurrents obtenu par un procédé conforme à l'invention.

**Brève description des dessins**

D'autres caractéristiques et avantages apparaîtront dans l'exposé détaillé de différents modes de réalisation de l'invention, l'exposé étant assorti d'exemples et de référence aux dessins joints.

Figures 1a à 1h sont des vues schématiques en coupe illustrant différentes étapes d'un procédé selon l'invention, la coupe étant effectuée suivant la normale à la surface du substrat.

Figure 2 est une vue schématique de dessus d'un calculateur obtenu par un procédé selon l'invention.

Figures 3a à 3g sont des vues schématiques en coupe illustrant différentes étapes d'un procédé selon l'invention, la coupe étant effectuée suivant la normale à la surface du substrat.

Il est à noter que les dessins décrits ci-avant sont schématiques et ne sont pas à l'échelle pas souci de lisibilité.

**Exposé détaillé des modes de réalisation**

Les éléments identiques ou assurant la même fonction porteront les mêmes références pour les différents modes de réalisation, par souci de simplification.

Un objet de l'invention est un procédé de fabrication d'un calculateur 1 à réseaux de neurones récurrents, comportant les étapes successives :

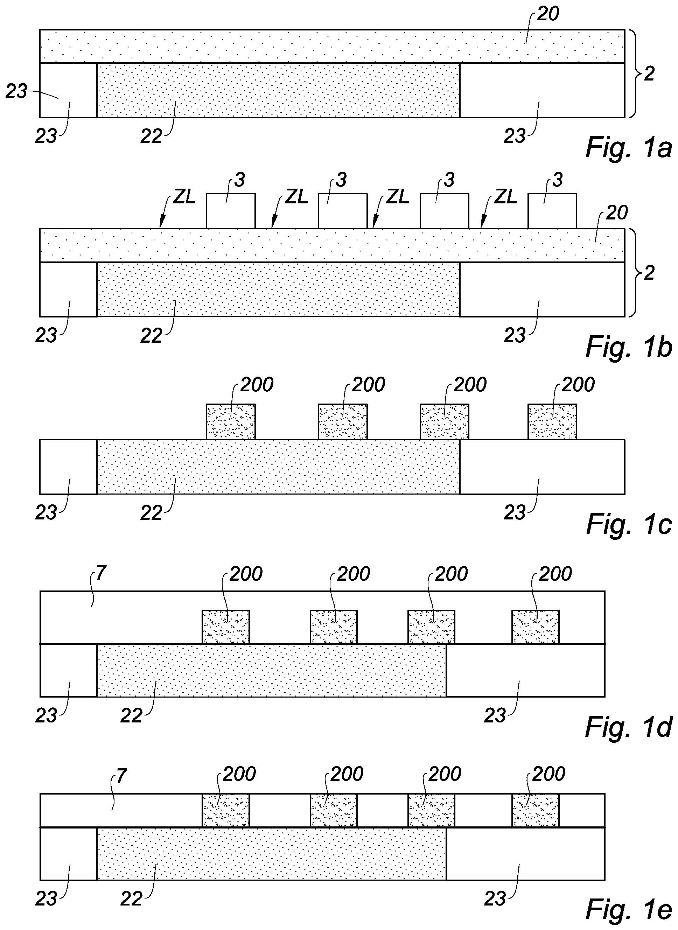

a) prévoir un substrat 2 comportant une première électrode 20 (illustré à la figure 1a) ;

b) former une première couche 3 de copolymères à blocs sur une partie de la première électrode 20 de sorte que la première électrode 20 présente des zones libres ZL avec une distribution spatiale aléatoire (illustré à la figure 1b) ;

c) graver les zones libres ZL de la première électrode 20 de manière à structurer la première électrode 20 ;

d) retirer la première couche 3 de copolymères à blocs (la situation à l'issue de l'étape d) est illustrée à la figure 1c) ;

e) former une couche mémoire 4, de type mémoire vive résistive, sur la première électrode structurée 200 lors de l'étape c) ;

f) former une deuxième électrode 21 sur la couche mémoire 4 ;

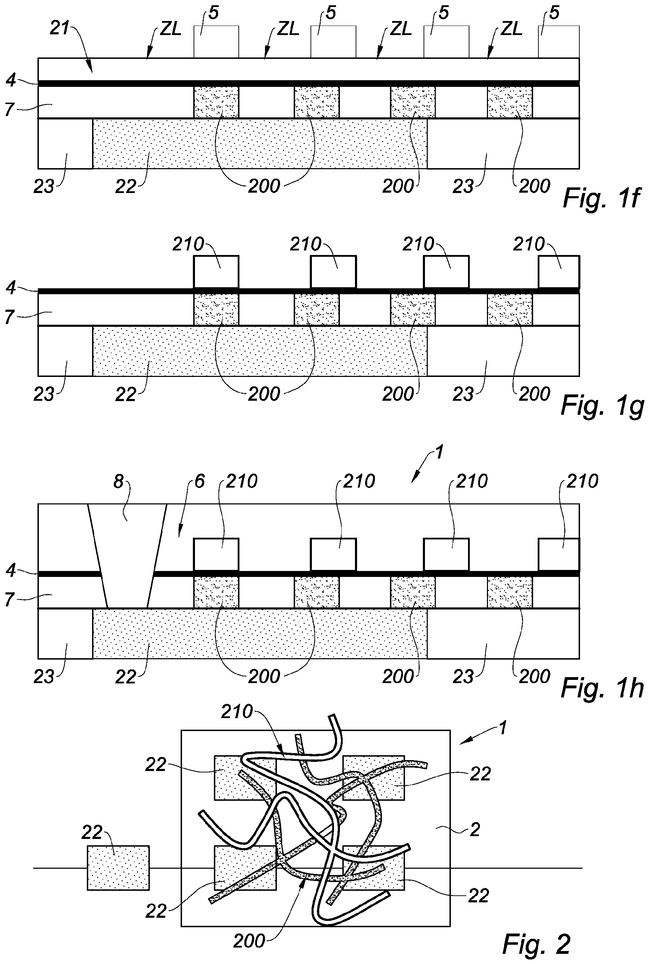

g) former une deuxième couche 5 de copolymère à blocs sur une partie de la deuxième électrode 21 de sorte que la deuxième électrode 21 présente des zones libres ZL avec une distribution spatiale aléatoire (la situation à l'issue de l'étape g) est illustrée à la figure 1f) ;

h) graver les zones libres ZL de la deuxième électrode 21 de manière à structurer la deuxième électrode 21 ;

i) retirer la deuxième couche 5 de copolymères à blocs (la situation à l'issue de l'étape i) est illustrée à la figure 1g).

Substrat

La première électrode 20 est avantageusement réalisée dans au moins un matériau sélectionné dans le groupe comportant Ti, TiN, Pt, Zr, Al, Hf, Ta, TaN, C, Cu, Ag. La première électrode 20 peut être réalisée dans un alliage de ces matériaux. La première électrode 20 présente préférentiellement une épaisseur comprise entre 3 nm et 100 nm. A titre d'exemples non limitatifs, la première électrode 20 peut être formée sur le substrat 2 par un dépôt physique en phase vapeur (PVD), un dépôt chimique en phase vapeur (CVD), ou encore par ALD (« *Atomic Layer Deposition* » en langue anglaise).

Le substrat 2 comporte préférentiellement une couche de métallisation 22 (pour la reprise de contact) et une couche d'un oxyde 23 tel que $SiO_2$ ou SiN. A titre d'exemple non limitatif, la couche de métallisation 22 peut être une structure du type Ti (10 nm)/AlCu (440 nm) / Ti (10 nm) / TiN (100 nm).

Formation de la première couche de copolymères à blocs

L'étape b) comporte avantageusement les étapes successives :

> b₁) former une couche d'un polymère aléatoire sur la première électrode ;
>
> b₂) greffer la couche du polymère aléatoire sur une partie de la première électrode ;
>
> b₃) former la première couche 3 de copolymères à blocs sur la couche du polymère aléatoire greffée lors de l'étape b₂) ;
>
> b₄) retirer la couche du polymère aléatoire greffée.

Le polymère aléatoire de la couche formée lors de l'étape b₁) est avantageusement sélectionné dans le groupe comportant un copolymère statistique, un homopolymère, une monocouche auto-assemblée. Le polymère aléatoire est avantageusement choisi lors de l'étape b₁) de sorte que la force d'attraction entre chacun des blocs de monomères du copolymère à blocs et la couche de polymère aléatoire (i.e. la couche de fonctionnalisation) sont équivalentes.

L'étape b₂) peut être exécutée à l'aide d'un traitement thermique, tel qu'un recuit thermique, ou par photoréticulation. La couche du polymère aléatoire qui n'a pas été greffée lors de l'étape b₂) est préférentiellement retirée à l'aide d'un traitement humide.

La première couche 3 de copolymères à blocs formée lors de l'étape b₃) est préférentiellement structurée à l'aide d'un recuit thermique.

A titre d'exemple, l'étape b₄) peut être un retrait sélectif lorsque le polymère aléatoire et les copolymères à blocs de la première couche 3 possèdent deux phases. L'étape b₄) peut être exécutée à l'aide d'un traitement UV suivi d'un développement par voie humide. L'étape b₄) peut également être exécutée par une gravure plasma.

Les copolymères à blocs de la première couche 3 sont avantageusement sélectionnés dans le groupe comportant :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO,
- le polystyrène et le poly(2-vinyl pyridine), noté PS-P2VP.

A titre d'exemple, lorsque les copolymères à blocs de la première couche 3 sont du polystyrène-b-poly(méthacrylate de méthyle), noté PS-b-PMMA, de forme lamellaire, le polymère aléatoire de la couche de fonctionnalisation est avantageusement du polystyrène-r-poly(méthacrylate de méthyle), noté PS-r-PMMA, comportant préférentiellement 50% en masse de PS et 50% en masse de PMMA. L'étape b₁) est préférentiellement exécutée par un dépôt à la tournette (« *spin-coating»* en langue anglaise). Le dépôt à la tournette peut être exécuté en diluant le polymère aléatoire dans un solvant organique. Lorsque le polymère aléatoire est le PS-r-PMMA, le solvant organique peut être de l'acétate de l'éther monométhylique du propylène glycol, noté PGMEA. La solution du polymère aléatoire dilué dans le solvant organique peut présenter une concentration massique de l'ordre de 1,5%. L'étape b₂) peut être exécutée par un recuit thermique à une température de l'ordre de 250°C pendant une durée de l'ordre de 10 minutes. Le recuit thermique peut être exécuté sur une table chauffante ou dans un four. Lorsque le polymère aléatoire peut être réticulé, un tel recuit thermique permet la réticulation du polymère aléatoire. L'étape b₂) peut comporter une étape de rinçage au cours de laquelle le surplus de polymère aléatoire est enlevé à l'aide d'un solvant. Lorsque le polymère aléatoire est du PS-r-PMMA, le solvant est préférentiellement le PGMEA. L'étape b₃) est préférentiellement exécutée par un dépôt à la tournette. Le dépôt à la tournette peut être exécuté en diluant le copolymère à blocs dans un solvant organique. Lorsque le copolymère à blocs est le PS-b-PMMA, le solvant organique peut être du PGMEA. La solution du copolymère à blocs dilué dans le solvant organique peut présenter une concentration massique de l'ordre de 1,5%. L'étape b₃) est avantageusement suivie d'un recuit thermique permettant l'auto-assemblage du copolymère à blocs PS-b-PMMA et le retrait sélectif du PS-r-PMMA. Le recuit thermique est préférentiellement exécuté à une température de l'ordre de 250°C pendant une durée de l'ordre de 10 minutes.

La première couche 3 de copolymères à blocs formée lors de l'étape b) présente avantageusement une épaisseur comprise entre 30 nm et 50 nm.

### Structuration de la première électrode

L'étape c) est préférentiellement exécutée par une gravure plasma. A titre d'exemples non limitatifs, il est possible d'utiliser comme gaz $O_2$, Ar, $COH_2$, $N_2H_2$. L'étape c) peut être également exécutée à l'aide d'un traitement UV suivi d'un développement humide (e.g. acide acétique).

### Retrait de la première couche de copolymères à blocs

L'étape d) est préférentiellement exécutée à l'aide d'un traitement UV suivi d'un développement par voie humide. L'étape d) peut également être exécutée par une gravure plasma.

### Formation de la couche mémoire

La couche mémoire 4 est avantageusement réalisée dans au moins un matériau sélectionné dans le groupe comportant $HfO_2$, $Al_2O_3$, $SiO_2$, ZrO, un oxyde de titane, un chalcogénure, $Ta_2O_5$. La couche mémoire 4 peut être formée d'une pluralité de sous-couches réalisées dans ces matériaux. A titre d'exemples non limitatifs, le chalcogénure peut être GeSe ou GeSbTe.

La couche mémoire 4 présente avantageusement une épaisseur inférieure ou égale à 10 nm.

Formation de la deuxième électrode

La deuxième électrode 21 est avantageusement réalisée dans au moins un matériau sélectionné dans le groupe comportant Ti, TiN, Pt, Zr, Al, Hf, Ta, TaN, C, Cu, Ag. La deuxième électrode 21 peut être réalisée dans un alliage de ces matériaux. La deuxième électrode 21 présente préférentiellement une épaisseur comprise entre 3 nm et 100 nm. A titre d'exemples non limitatifs, la deuxième électrode 21 peut être formée sur la couche mémoire 4 par un dépôt physique en phase vapeur (PVD), un dépôt chimique en phase vapeur (CVD), ou encore par ALD (« *Atomic Layer Deposition* » en langue anglaise).

Formation de la deuxième couche de copolymères à blocs

L'étape g) comporte avantageusement les étapes successives :

g$_1$) former une couche d'un polymère aléatoire sur la deuxième électrode ;
g$_2$) greffer la couche du polymère aléatoire sur une partie de la deuxième électrode ;
g$_3$) former la deuxième couche 5 de copolymères à blocs sur la couche du polymère aléatoire greffée lors de l'étape g$_2$) ;
g$_4$) retirer la couche du polymère aléatoire greffée.

Le polymère aléatoire de la couche formée lors de l'étape g$_1$) est avantageusement sélectionné dans le groupe comportant un copolymère statistique, un homopolymère, une monocouche auto-assemblée. Le polymère aléatoire est avantageusement choisi lors de l'étape g$_1$) de sorte que la force d'attraction entre chacun des blocs de monomères du copolymère à blocs et la couche de polymère aléatoire (i.e. la couche de fonctionnalisation) sont équivalentes.

L'étape g$_2$) peut être exécutée à l'aide d'un traitement thermique, tel qu'un recuit thermique, ou par photoréticulation. La couche du polymère aléatoire qui n'a pas été greffée lors de l'étape g$_2$) est préférentiellement retirée à l'aide d'un traitement humide.

La deuxième couche 5 de copolymères à blocs formée lors de l'étape g$_3$) est préférentiellement structurée à l'aide d'un recuit thermique.

A titre d'exemple, l'étape g$_4$) peut être un retrait sélectif lorsque le polymère aléatoire et les copolymères à blocs de la deuxième couche 5 possèdent deux phases. L'étape g$_4$) peut être exécutée à l'aide d'un traitement UV suivi d'un développement par voie humide. L'étape

g$_4$) peut également être exécutée par une gravure plasma.

Les copolymères à blocs de la deuxième couche 5 sont avantageusement sélectionnés dans le groupe comportant :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO,
- le polystyrène et le poly(2-vinyl pyridine), noté PS-P2VP.

A titre d'exemple, lorsque les copolymères à blocs de la deuxième couche 5 sont du polystyrène-b-poly(méthacrylate de méthyle), noté PS-b-PMMA, de forme lamellaire, le polymère aléatoire de la couche de fonctionnalisation est avantageusement du polystyrène-r-poly(méthacrylate de méthyle), noté PS-r-PMMA, comportant préférentiellement 50% en masse de PS et 50% en masse de PMMA. L'étape g$_1$) est préférentiellement exécutée par un dépôt à la tournette (« *spin-coating»* en langue anglaise). Le dépôt à la tournette peut être exécuté en diluant le polymère aléatoire dans un solvant organique. Lorsque le polymère aléatoire est le PS-r-PMMA, le solvant organique peut être de l'acétate de l'éther monométhylique du propylène glycol, noté PGMEA. La solution du polymère aléatoire dilué dans le solvant organique peut présenter une concentration massique de l'ordre de 1,5%. L'étape g$_2$) peut être exécutée par un recuit thermique à une température de l'ordre de 250°C pendant une durée de l'ordre de 10 minutes. Le recuit thermique peut être exécuté sur une table chauffante ou dans un four. Lorsque le polymère aléatoire peut être réticulé, un tel recuit thermique permet la réticulation du polymère aléatoire. L'étape g$_2$) peut comporter une étape de rinçage au cours de laquelle le surplus de polymère aléatoire est enlevé à l'aide d'un solvant. Lorsque le polymère aléatoire est du PS-r-PMMA, le solvant est préférentiellement le PGMEA. L'étape g$_3$) est préférentiellement exécutée par un dépôt à la tournette. Le dépôt à la tournette peut être exécuté en diluant le copolymère à blocs dans un solvant organique. Lorsque le copolymère à blocs est le PS-b-PMMA, le solvant organique peut être du PGMEA. La solution du copolymère à blocs dilué dans le solvant organique peut présenter une concentration massique de l'ordre de 1,5%. L'étape g$_3$) est avantageusement suivie d'un recuit thermique permettant l'auto-assemblage du copolymère à blocs PS-b-PMMA et le retrait sélectif du PS-r-PMMA. Le recuit thermique est préférentiellement exécuté à une température de l'ordre de 250°C pendant une durée de l'ordre de 10 minutes.

La deuxième couche 5 de copolymères à blocs formée respectivement lors de l'étape g) présente avantageusement une épaisseur comprise entre 30 nm et 50 nm.

## Structuration de la deuxième électrode

L'étape h) est préférentiellement exécutée par une gravure plasma. A titre d'exemples non limitatifs, il est possible d'utiliser comme gaz $O_2$, Ar, $COH_2$, $N_2H_2$. L'étape h) peut être également exécutée à l'aide d'un traitement UV suivi d'un développement humide (e.g. acide acétique).

## Retrait de la deuxième couche de copolymères à blocs

L'étape i) est préférentiellement exécutée à l'aide d'un traitement UV suivi d'un développement par voie humide. L'étape i) peut également être exécutée par une gravure plasma.

## Encapsulation

Comme illustré à la figure 1h, le procédé comporte avantageusement une étape j) consistant à former une couche d'encapsulation 6 sur la deuxième électrode structurée 210 lors de l'étape h), l'étape j) étant exécutée après l'étape i). La couche d'encapsulation 6 est préférentiellement une couche d'un oxyde tel que $SiO_2$ ou SiN.

Par ailleurs, comme illustré à la figure 1d, le procédé comporte avantageusement une étape $d_1$) consistant à former une couche d'encapsulation 7 sur la première électrode structurée 200. L'étape $d_1$) est exécutée après l'étape d) et avant l'étape e). La couche d'encapsulation 7 est préférentiellement une couche d'un oxyde tel que $SiO_x$ ou SiN. L'étape $d_1$) est avantageusement suivie d'une étape $d_2$) d'aplanissement de la couche d'encapsulation 7 pouvant être exécutée par polissage mécano-chimique (CMP pour *«Chemical-Mechanical Polishing* » en langue anglaise). En l'absence des étapes $d_1$) et $d_2$), la couche mémoire 4 formée lors de l'étape e) suit la topologie de la première électrode structurée 200.

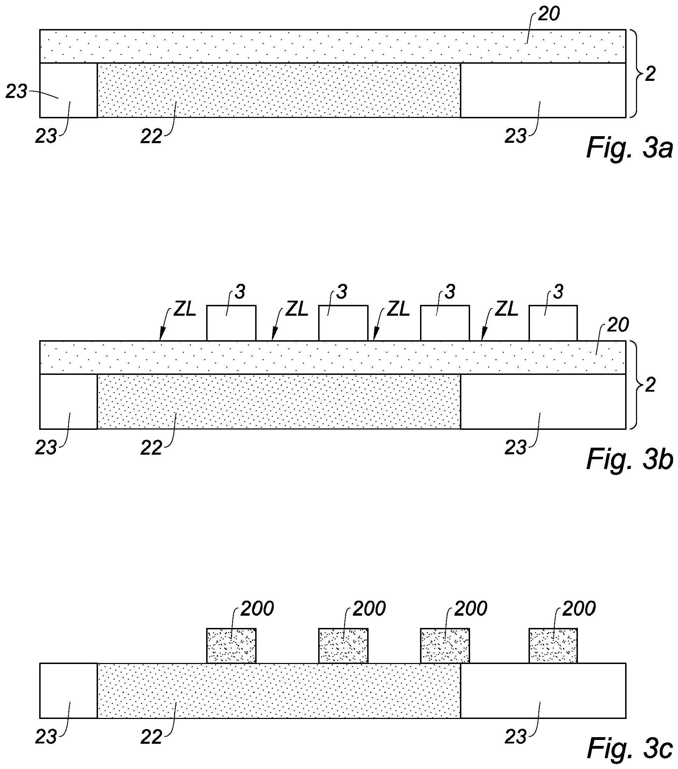

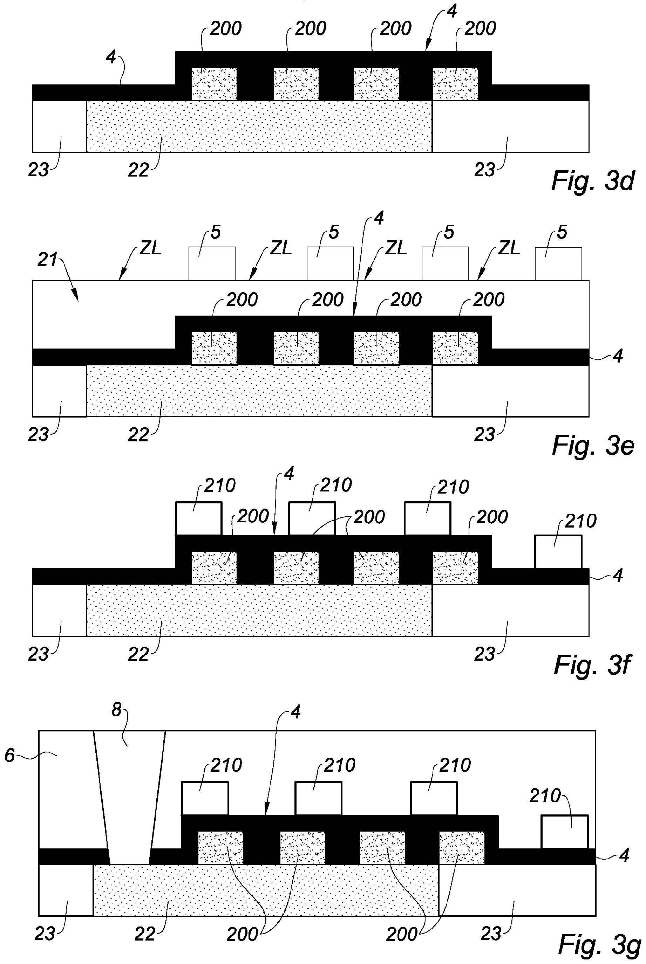

Plus précisément, comme illustré aux figures 3a à 3g, en l'absence des étapes $d_1$) et $d_2$), la couche mémoire 4 est formée lors de l'étape e), directement sur le substrat 2 et directement sur la première électrode structurée 200, en suivant la topologie de la première électrode structurée 200 (cf. figure 3d). Ce mode de réalisation est particulièrement avantageux car il permet de s'affranchir notamment de l'étape $d_2$) de polissage mécano-chimique qui peut s'avérer délicate à effectuer en raison de la géométrie de la première électrode structurée 200 (le ratio entre son épaisseur et son pas étant faible).

En l'absence des étapes $d_1$) et $d_2$), la couche mémoire 4 formée lors de l'étape e) présente avantageusement une épaisseur, notée E, vérifiant :

$$p/2 \leq E \leq p$$

où p est le pas de la première électrode structurée 200 formant une structure périodique. Une telle épaisseur E de la couche mémoire 4 permet d'obtenir une topologie de surface quasi-plane de manière à faciliter la formation de la deuxième électrode 21 lors de l'étape f) (illustrée à la figure 3e).

Le pas p de la première électrode structurée 200 correspond au pas de la première couche 3 de copolymères à blocs formée lors de l'étape b). A titre d'exemple non limitatif, lorsque la première couche 3 de copolymères à blocs formée lors de l'étape b) est réalisée en PS-PMMA, le pas de ladite première couche 3 est défini par la masse molaire des copolymères à blocs, comme évoqué dans le document Kim et al, « Directed assembly of high molecular weight block pofymers : highly ordered line patterns of perpendicularfy oriented lamellae with large periods», ACS Nano, 7(3), pp. 1952-60, 2013. On pourra donc choisir la masse molaire de la première couche 3 de copolymères à blocs formée lors de l'étape b) de manière à contrôler le pas p de la première électrode structurée 200. A titre d'exemple non limitatif, le pas p de la première électrode structurée 200 peut être de l'ordre de 20 nm.

En l'absence des étapes $d_1$) et $d_2$), la couche mémoire 4 est avantageusement réalisée dans au moins un matériau sélectionné dans le groupe comportant :

- $HfO_x$, x<2 ;
- $Al_2O_x$, x<3 ;
- $SiO_x$, x<2 ;
- $ZrO_x$, x<3 ;
- $TiO_x$, x<2 ;
- $Ta_2O_x$, x<5.

De tels matériaux sont des oxydes sous-stœchiométriques permettant de créer un filament électriquement conducteur lorsqu'ils sont soumis à une différence de potentiels élevée. De tels matériaux peuvent ainsi former, avec les première et deuxième électrodes structurées 200, 210, une mémoire vive résistive.

## Contacts électriques

Comme illustré à la figure 1h, le procédé comporte préférentiellement une étape k) consistant à former un plot 8 de contact électrique, en contact avec la couche de métallisation 22. L'étape k) est exécutée après l'étape j). L'étape k) comporte une étape de gravure de la couche d'encapsulation 6 formée sur la deuxième électrode structurée 210.

L'invention ne se limite pas aux modes de réalisation exposés. L'homme du métier est mis à même de considérer leurs combinaisons techniquement opérantes, et de leur substituer des équivalents.

**Revendications**

**1.** Procédé de fabrication d'un calculateur (1) à réseaux de neurones récurrents, comportant les étapes successives :

a) prévoir un substrat (2) comportant une première électrode (20) ;
b) former une première couche (3) de copolymères à blocs sur une partie de la première électrode (20) de sorte que la première électrode (20) présente des zones libres (ZL) avec une distribution spatiale aléatoire ;
c) graver les zones libres (ZL) de la première électrode (20) de manière à structurer la première électrode (20) ;
d) retirer la première couche (3) de copolymères à blocs ;
e) former une couche mémoire (4), de type mémoire vive résistive, sur la première électrode structurée (200) lors de l'étape c) ;
f) former une deuxième électrode (21) sur la couche mémoire ;
g) former une deuxième couche (5) de copolymère à blocs sur une partie de la deuxième électrode (21) de sorte que la deuxième électrode (21) présente des zones libres (ZL) avec une distribution spatiale aléatoire ;
h) graver les zones libres (ZL) de la deuxième électrode (21) de manière à structurer la deuxième électrode (21) ;
i) retirer la deuxième couche (5) de copolymères à blocs.

**2.** Procédé selon la revendication 1, dans lequel l'étape b) comporte les étapes successives :

$b_1$) former une couche d'un polymère aléatoire sur la première électrode (20) ;
$b_2$) greffer la couche du polymère aléatoire sur une partie de la première électrode (20) ;
$b_3$) former la première couche (3) de copolymères à blocs sur la couche du polymère aléatoire greffée lors de l'étape $b_2$) ;
$b_4$) retirer la couche du polymère aléatoire greffée.

**3.** Procédé selon la revendication 1 ou 2, dans lequel l'étape g) comporte les étapes successives :

$g_1$) former une couche d'un polymère aléatoire sur la deuxième électrode (21) ;
$g_2$) greffer la couche du polymère aléatoire sur une partie de la deuxième électrode (21) ;
$g_3$) former la deuxième couche (5) de copolymères à blocs sur la couche du polymère aléatoire greffée lors de l'étape $g_2$) ;
$g_4$) retirer la couche du polymère aléatoire greffée.

**4.** Procédé selon la revendication 2 ou 3, dans lequel le polymère aléatoire est sélectionné dans le groupe comportant un copolymère statistique, un homopolymère, une monocouche auto-assemblée.

**5.** Procédé selon l'une des revendications 1 à 4, dans lequel les copolymères à blocs de la première couche (3) et de la deuxième couche (5) sont sélectionnés dans le groupe comportant :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO,
- le polystyrène et le poly(2-vinyl pyridine), noté PS-P2VP.

**6.** Procédé selon l'une des revendications 1 à 5, dans lequel la couche mémoire (4) est réalisée dans au moins un matériau sélectionné dans le groupe comportant $HfO_2$, $Al_2O_3$, $SiO_2$, ZrO, un oxyde de titane, un chalcogénure, $Ta_2O_5$.

**7.** Procédé selon l'une des revendications 1 à 6, dans lequel les première et deuxième électrodes (20, 21) sont réalisées dans au moins un matériau sélectionné dans le groupe comportant Ti, TiN, Pt, Zr, Al, Hf, Ta, TaN, C, Cu, Ag.

**8.** Procédé selon l'une des revendications 1 à 7, dans lequel la première couche (3) de copolymères à blocs et la deuxième couche (5) de copolymères à blocs formées respectivement lors des étapes b) et g) présentent une épaisseur comprise entre 30 nm et 50 nm.

**9.** Procédé selon l'une des revendications 1 à 8, comportant une étape j) consistant à former une couche d'encapsulation (6) sur la deuxième électrode structurée (210) lors de l'étape h), l'étape j) étant exécutée après l'étape i).

**10.** Procédé selon l'une des revendications 1 à 9, dans lequel la première électrode structurée (200) lors de l'étape c) présente un pas, noté p, et dans lequel l'étape e) est exécutée de sorte que la couche mémoire (4) présente une épaisseur, notée E, vérifiant :

$$p/2 \leq E \leq p.$$

**11.** Calculateur (1) à réseaux de neurones récurrents obtenu par le procédé selon l'une des revendications 1 à 10.

**Patentansprüche**

**1.** Verfahren zur Herstellung eines Rechners (1) mit rekurrenten neuronalen Netzen, das folgende aufeinanderfolgende Schritte umfasst:

> a) Bereitstellen eines Substrats (2) mit einer ersten Elektrode (20);
> b) Bilden einer ersten Schicht (3) aus Blockcopolymeren auf einem Abschnitt der ersten Elektrode (20) derart, dass die erste Elektrode (20) freie Bereiche (ZL) mit einer zufälligen räumlichen Verteilung aufweist;
> c) Ätzen der freien Bereiche (ZL) der ersten Elektrode (20), damit die erste Elektrode (20) strukturiert wird;
> d) Entfernen der ersten Schicht (3) aus Blockcopolymeren;
> e) Bilden einer Speicherschicht (4) vom Typ resistiver Arbeitsspeicher auf der in Schritt c) strukturierten ersten Elektrode (200);
> f) Bilden einer zweiten Elektrode (21) auf der Speicherschicht;
> g) Bilden einer zweiten Schicht (5) aus Blockcopolymeren auf einem Abschnitt der zweiten Elektrode (21), damit die zweite Elektrode (21) freie Bereiche (ZL) mit einer zufälligen räumlichen Verteilung aufweist;
> h) Ätzen der freien Bereiche (ZL) der zweiten Elektrode (21), damit die zweite Elektrode (21) strukturiert wird;
> i) Entfernen der zweiten Schicht (5) aus Blockcopolymeren.

**2.** Verfahren nach Anspruch 1, wobei Schritt b) folgende aufeinanderfolgende Schritte umfasst:

> $b_1$) Bilden einer Schicht aus einem Polymer mit zufälliger Verteilung auf der ersten Elektrode (20);
> $b_2$) Aufpfropfen der Schicht aus dem Polymer mit zufälliger Verteilung auf einem Abschnitt der ersten Elektrode (20);
> $b_3$) Bilden der ersten Schicht (3) aus Blockcopolymeren auf der Schicht aus dem Polymer mit zufälliger Verteilung, das in Schritt $b_2$) aufgepfropft wurde;
> $b_4$) Entfernen der Schicht aus dem aufgepfropften Polymer mit zufälliger Verteilung.

**3.** Verfahren nach Anspruch 1 oder 2, wobei Schritt g) folgende aufeinanderfolgende Schritte umfasst:

> $g_1$) Bilden einer Schicht aus einem Polymer mit zufälliger Verteilung auf der zweiten Elektrode (21);
> $g_2$) Aufpfropfen der Schicht aus dem Polymer mit zufälliger Verteilung auf einem Abschnitt der zweiten Elektrode (21);
> $g_3$) Bilden der zweiten Schicht (5) aus Blockcopolymeren auf der Schicht aus dem Polymer mit zufälliger Verteilung, das in Schritt $g_2$) aufgepfropft wurde;
> $g_4$) Entfernen der Schicht aus dem aufgepfropften Polymer mit zufälliger Verteilung.

**4.** Verfahren nach Anspruch 2 oder 3, wobei das Polymer mit zufälliger Verteilung aus der Gruppe ausgewählt wird, die ein statistisches Copolymer, ein Homopolymer und eine durch Selbstorganisation gebildete Monoschicht umfasst.

**5.** Verfahren nach einem der Ansprüche 1 bis 4, wobei die Blockcopolymere der ersten Schicht (3) und der zweiten Schicht (5) aus der Gruppe ausgewählt werden, die Folgendes umfasst:

> - Polystyrol und Polymethylmethacrylat, Kurzzeichen PS-PMMA;
> - Polystyrol und Polymilchsäure, Kurzzeichen PS-PLA;
> - Polystyrol und Polyethylenoxid, Kurzzeichen PS-PEO;
> - Polystyrol und Polydimethylsiloxan, Kurzzeichen PS-PDMS;
> - Polystyrol, Polymethylmethacrylat und Polyethylenoxid, Kurzzeichen PS-PMMA-PEO;
> - Polystyrol und Poly(2-vinylpyridin), Kurzzeichen PS-P2VP.

**6.** Verfahren nach einem der Ansprüche 1 bis 5, wobei die Speicherschicht (4) aus mindestens einem Material gefertigt wird, das aus der Gruppe umfassend $HfO_2$, $Al_2O_3$, $SiO_2$, $ZrO$, ein Titanoxid, ein Chalkogenid, $Ta_2O_5$ ausgewählt ist.

**7.** Verfahren nach einem der Ansprüche 1 bis 6, wobei die erste und zweite Elektrode (20, 21) aus mindestens einem Material gefertigt werden, das aus der Gruppe umfassend Ti, TiN, Pt, Zr, Al, Hf, Ta, TaN, C, Cu, Ag ausgewählt ist.

**8.** Verfahren nach einem der Ansprüche 1 bis 7, wobei die erste Schicht (3) aus Blockcopolymeren und die zweite Schicht (5) aus Blockcopolymeren, die in Schritt b) beziehungsweise g) gebildet wird, eine Dicke zwischen 30 nm und 50 nm aufweisen.

**9.** Verfahren nach einem der Ansprüche 1 bis 8, das einen Schritt j) umfasst, der im Bilden einer Verkapselungsschicht (6) auf der in Schritt h) strukturierten zweiten Elektrode (210) besteht, wobei Schritt j) nach Schritt i) ausgeführt wird.

**10.** Verfahren nach einem der Ansprüche 1 bis 9, wobei die in Schritt c) strukturierte erste Elektrode (200) einen mit p bezeichneten Abstand aufweist, und wobei Schritt e) derart ausgeführt wird, dass die Speicherschicht (4) eine mit E bezeichnete Dicke aufweist, wobei Folgendes erfüllt wird:

$$p/2 \leq E \leq p.$$

**11.** Rechner (1) mit rekurrenten neuronalen Netzen, der mit dem Verfahren nach einem der Ansprüche 1 bis 10 erhalten wird.

**Claims**

**1.** Process for fabricating a recurrent-neural-network computer (1), comprising the successive steps of:

a) providing a substrate (2) comprising a first electrode (20);
b) forming a first block-copolymer layer (3) on one portion of the first electrode (20) so that the first electrode (20) contains free zones (ZL) with a random spatial distribution;
c) etching the free zones (ZL) of the first electrode (20) so as to structure the first electrode (20);
d) removing the first block-copolymer layer (3);
e) forming a resistive random-access memory layer (4) on the first electrode (200) structured in step c);
f) forming a second electrode (21) on the memory layer;
g) forming a second block-copolymer layer (5) on one portion of the second electrode (21) so that the second electrode (21) contains free zones (ZL) with a random spatial distribution;
h) etching the free zones (ZL) of the second electrode (21) so as to structure the second electrode (21);
i) removing the second block-copolymer layer (5).

**2.** Process according to Claim 1, wherein step b) comprises the successive steps of:

b$_1$) forming a layer of a random polymer on the first electrode (20);
b$_2$) grafting the random-polymer layer to one portion of the first electrode (20);
b$_3$) forming the first block-copolymer layer (3) on the random-polymer layer grafted in step b2);
b$_4$) removing the grafted random-polymer layer.

**3.** Process according to Claim 1 or 2, wherein step g) comprises the successive steps of:

g$_1$) forming a layer of a random polymer on the second electrode (21);
g$_2$) grafting the random-polymer layer to one portion of the second electrode (21);
g$_3$) forming the second block-copolymer layer (5) on the random-polymer layer grafted in step g$_2$);
g$_4$) removing the grafted random-polymer layer.

**4.** Process according to Claim 2 or 3, wherein the random polymer is selected from the group containing a statistical copolymer, a homopolymer, a self-assembled monolayer.

**5.** Process according to one of Claims 1 to 4, wherein the block copolymers of the first layer (3) and of the second layer (5) are selected from the group containing:

- polystyrene and polymethyl methacrylate, denoted PS-PMMA;
- polystyrene and polylactic acid, denoted PS-PLA;
- polystyrene and poly(ethylene oxide), denoted PS-PEO;
- polystyrene and polydimethylsiloxane, denoted PS-PDMS;
- polystyrene, polymethyl methacrylate and poly(ethylene oxide), denoted PS-PMMA-PEO,
- polystyrene and poly(2-vinyl pyridine), denoted PS-P2VP.

**6.** Process according to one of Claims 1 to 5, wherein the memory layer (4) is made from at least one material selected from the group containing HfO$_2$, Al$_2$O$_3$, SiO$_2$, ZrO, a titanium oxide, a chalcogenide, Ta$_2$O$_5$.

**7.** Process according to one of Claims 1 to 6, wherein the first and second electrodes (20, 21) are made from at least one material selected from the group containing Ti, TiN, Pt, Zr, Al, Hf, Ta, TaN, C, Cu, Ag.

**8.** Process according to one of Claims 1 to 7, wherein the first block-copolymer layer (3) and the second block-copolymer layer (5) formed in steps b) and g) have a thickness comprised between 30 nm and 50 nm, respectively.

**9.** Process according to one of Claims 1 to 8, comprising a step j) consisting in forming an encapsulation layer (6) on the second electrode (210) structured in step h), step j) being executed after step i).

10. Process according to one of Claims 1 to 9, wherein the first electrode (200) structured in step c) has a pitch, denoted p, and wherein step e) is executed so that the memory layer (4) has a thickness, denoted E, respecting:

$$p/2 \leq E \leq p.$$

11. Recurrent-neural-network computer (1) obtained using the process according to one of Claims 1 to 10.

Fig. 1a

Fig. 1b

Fig. 1c

Fig. 1d

Fig. 1e

Fig. 1f

Fig. 1g

Fig. 1h

Fig. 2

**Fig. 3a**

**Fig. 3b**

**Fig. 3c**

Fig. 3d

Fig. 3e

Fig. 3f

Fig. 3g

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010220523 A1

**Littérature non-brevet citée dans la description**

- **E.C. DEMIS et al.** Atomic switch networks - nanoarchitectonic design of a complex systemfor natural computing. *Nanotechnology,* 2015, vol. 26, 204003

- **KIM et al.** Directed assembly of high molecular weight block pofymers : highly ordered line patterns of perpendicularfy oriented lamellae with large periods. *ACS Nano,* 2013, vol. 7 (3), 1952-60